# FASCICULE DE BREVET EUROPEEN

(11) **EP 4 191 345 B1**
(45) Date de publication et mention de la délivrance du brevet: **04.06.2025**
(21) Numéro de dépôt: 21212556.1
(22) Date de dépôt: 06.12.2021
(51) Int. Cl.: G04B 15/08, G04D 3/00, G04B 1/14, G04B 15/14, B81B 3/00, C23C 16/27, C23C 16/30, C23C 16/505, C23C 16/56

(54) **ENSEMBLE FONCTIONNEL DE MICROMECANIQUE AVEC UN REVETEMENT TRIBOLOGIQUE**
FUNKTIONELLE MIKROMECHANIKANORDNUNG MIT EINER TRIBOLOGISCHEN BESCHICHTUNG
MICROMECHANICAL FUNCTIONAL ASSEMBLY WITH A TRIBOLOGICAL COATING

(43) Date de publication de la demande: 07.06.2023
(73) Titulaire: The Swatch Group Research and Development Ltd, 2074 Marin (CH)
(72) Inventeur: FAURE, Cédric, 2016 Cortaillod (CH); MANASTERSKI, Christian, 2019 Rochefort (CH)
(74) Mandataire: ICB SA

(56) Documents cités:
- EP-A1- 0 732 635
- EP-A1- 2 631 721
- EP-A1- 3 226 080
- US-A- 6 013 191
- VIVENSANG C ET AL: "Reactive ion etching of diamond and diamond-like carbon films", DIAMOND AND RELATED MATERIALS, ELSEVIER SCIENCE PUBLISHERS , AMSTERDAM, NL, vol. 3, no. 4-6, 1 April 1994 (1994-04-01), pages 645 - 649, XP024179093, ISSN: 0925-9635, [retrieved on 19940401], DOI: 10.1016/0925-9635(94)90241-0
- TEII K. ET AL: "Negative Bias Dependence of Sulfur and Fluorine Incorporation in Diamond Films Etched by an SF[sub 6] Plasma", JOURNAL OF THE ELECTROCHEMICAL SOCIETY, vol. 148, no. 2, 1 January 2001 (2001-01-01), pages G55, XP055914488, ISSN: 0013-4651, Retrieved from the Internet <URL:https://iopscience.iop.org/article/10.1149/1.1339868/pdf> DOI: 10.1149/1.1339868

## Description

### Domaine technique de l'invention

La présente invention concerne un ensemble fonctionnel de micromécanique comprenant au moins une pièce munie de surfaces soumises à un contact par frottement nécessitant un revêtement tribologique. L'ensemble fonctionnel de micromécanique se rapporte plus spécifiquement à un couple de pièces micromécaniques horlogères coopérant mécaniquement l'une avec l'autre telles qu'une roue d'échappement et des palettes d'une ancre.

### Arrière-plan technologique

Lors de l'apparition des technologies de dépôt de diamant par voie chimique en phase gazeuse (diamant CVD), beaucoup d'espoirs avaient été émis concernant la tribologie, grâce à la dureté intrinsèque du diamant. Malheureusement, le frottement à sec entre deux surfaces de diamant n'est pas tribologiquement viable car il conduit à une adhésion entre les pièces horlogères en contact. Ceci est dû à la création de liaisons entre les atomes de carbone (C-C) des deux matériaux partenaires du couple Diamant vs Diamant. Pour minimiser cet effet adhésif, le couple de matériaux Diamant vs Diamant doit être en présence d'un environnement doté d'une humidité relative (%HR) au moins égale à 50%. Cette valeur seuil de 50%HR permet l'approvisionnement de microgouttelettes d'eau (H₂O) dans la surface de contact. Ceci diminue alors l'effort tangentiel de déplacement F_{T} d'une surface par rapport à une autre surface. Ces microgouttelettes jouent donc le rôle de lubrifiants locaux favorisant le mouvement relatif des pièces horlogères en contact. Sous cette valeur seuil, le phénomène d'adhésion est exacerbé, avec des instabilités de contact intervenant sur des temps de sollicitations courts.

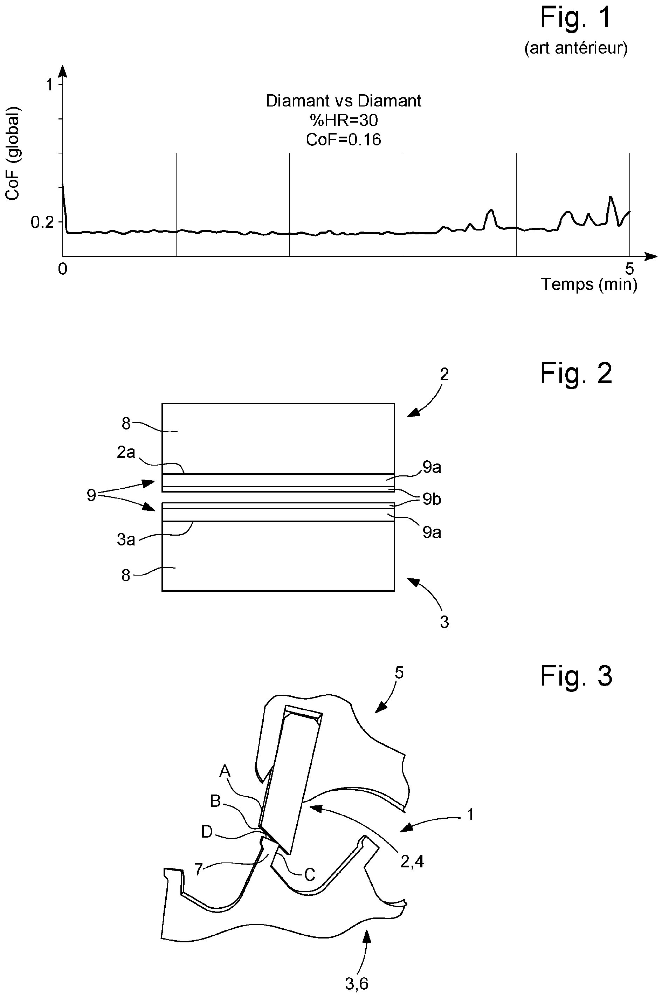

Ainsi, dans les conditions de contact existant en mouvement (effort normal faible et effort tangentiel élevé), le coefficient de frottement global, noté CoF _{(Coefficient Of Friction)}, du couple Diamant vs Diamant peut être inférieur à 0.2 comme illustré à la figure 1. Malheureusement, ces conditions environnementales ne garantissent pas la stabilité tribologique du couple de matériaux au-delà de 5 minutes de test. En effet, des instabilités de frottement apparaissent dès 3.5 minutes de test.

Le défi réside donc dans le fait d'utiliser ce couple Diamant/Diamant dans un ensemble fonctionnel micromécanique en garantissant sans lubrifiant un comportement tribologique stable sur une plus longue durée.

Le document EP0732635A1 présente un couple diamant contre diamant dont la couche externe est complétée d'atomes d'oxygène, de fluor et soufre.

### Résumé de l'invention

L'invention a pour objet de pallier aux désavantages précités en modifiant les propriétés tribologiques de la couche de diamant. En effet, comme expliqué précédemment, les atmosphères d'hydrogène, d'oxygène ou d'humidité sont, en utilisation sur le long terme, difficiles à tenir. L'objet de l'invention est de remplacer le lien atomique OH ou H de passivation provoqué par les milieux cités ci-dessus par d'autres molécules. Ces modifications d'extrême surface destinées à changer les propriétés tribologiques sont réalisées, selon l'invention, en fonctionnalisant la couche de diamant. Plus précisément, selon l'invention, la couche de diamant est fonctionnalisée avec un composé de soufre et de fluor.

Ainsi, la présente invention, définie par la revendication 1 annexée, se rapporte à un ensemble fonctionnel de micromécanique comprenant au moins une première pièce avec une première surface fonctionnelle destinée à venir en contact de frottement avec une deuxième surface fonctionnelle, ladite deuxième surface fonctionnelle appartenant, soit à ladite première pièce soit à au moins une deuxième pièce constituant avec ladite première pièce ledit ensemble fonctionnel, ledit ensemble fonctionnel étant caractérisé en ce que la première surface fonctionnelle et la deuxième surface fonctionnelle sont formées d'une première couche comprenant du diamant ultrananocristallin, nanocristallin ou microcristallin, ladite première couche étant surmontée d'une deuxième couche comportant des atomes de S et de F. On comprendra que la première couche peut être de matière avec le substrat constituant les première et deuxième pièces ou distincte du substrat.

Une amélioration du comportement tribologique de ces surfaces fonctionnelles a été observée lors d'essais. Cette amélioration pourrait être attribuée au S permettant de se préserver de l'apparition de liaisons (C-C) lorsque l'humidité relative n'est plus suffisante pour jouer ce rôle. Ainsi, il est possible de prévoir un fonctionnement d'un système mobile horloger, tel qu'un échappement à ancre suisse sans lubrification du contact palette/roue d'échappement, avec des performances au moins équivalentes à celles des références standards.

Cette amélioration du comportement tribologique est plus particulièrement observée lorsque les deux surfaces fonctionnelles en contact sont revêtues avec une couche tribologique de même composition.

La présente invention, telle que définie dans la revendication 9 annexée, se rapporte également au procédé de fonctionnalisation du diamant par gravure ionique réactive. La gravure ionique réactive est généralement utilisée pour la gravure profonde sur silicium. Il a été constaté par les inventeurs qu'en utilisant un équipement de gravure par ions réactifs à très faible puissance, typiquement entre 30 et 70 W, il est possible de synthétiser ce composé de S et F sur une pièce, telle une pièce d'horlogerie qui a de faibles dimensions.

### Brève description des figures

Les buts, avantages et caractéristiques apparaitront à la lumière des figures suivantes :
- la figure 1 représente la courbe du coefficient de frottement global (CoF_{(global)}) en fonction du temps, du couple diamant microcristallin/diamant microcristallin non lubrifié selon l'art antérieur, pour un taux d'humidité relative de 30%.
- la figure 2 représente schématiquement en coupe une portion de deux pièces de l'ensemble fonctionnel selon l'invention.
- la figure 3 représente partiellement un ensemble fonctionnel comprenant deux pièces, à savoir une roue d'échappement et une palette d'ancre avec des surfaces de contact fonctionnalisées selon l'invention.
- la figure 4 représente une image en microscopie électronique de la morphologie de la deuxième couche de S et F, avec une structure en bâtonnets.
- les figures 5a et 5b représentent respectivement les résultats tribologiques pour une distance de 25m, pour un ensemble fonctionnel comprenant deux pièces. A la figure 5a, à titre comparatif non couvert par l'invention, une pièce est revêtue sur sa surface fonctionnelle de diamant microcristallin MCD et l'autre pièce de diamant microcristallin fonctionnalisé au SF6. A la figure 5b, selon l'invention, les deux pièces sont revêtues sur leur surface fonctionnelle de diamant microcristallin fonctionnalisé au SF6.
- la figure 6 représente les résultats tribologiques pour le couple de la figure 5b sur une plus longue distance de 2500m.
- les figures 7a et 7b représentent l'amplitude du balancier respectivement pour un couple roue d'échappement/ancre de référence et un couple roue d'échappement/ancre selon l'invention avec une couche de diamant microcristallin fonctionnalisé au SF6.
- la figure 8 est une vue schématique de l'équipement utilisé pour la fonctionnalisation du diamant.

### Description détaillée de l'invention

La présente invention se rapporte à un ensemble fonctionnel comprenant au moins une pièce soumise sur sa ou ses surfaces dites fonctionnelles ou de contact aux frottements. L'ensemble fonctionnel selon l'invention peut comporter une seule pièce avec deux surfaces fonctionnelles destinées à être en contact par frottement. Par exemple, dans le domaine horloger, il peut s'agir d'un ressort de barillet formé d'une lame avec une face du ressort destinée à être en contact avec une autre face du ressort. En variante, l'ensemble fonctionnel peut comporter au moins deux pièces avec respectivement chaque pièce comportant une surface fonctionnelle destinée à être soumise aux frottements avec une surface fonctionnelle d'une autre pièce. Par exemple, dans le domaine horloger, l'ensemble fonctionnel 1 peut comporter une première pièce 2 qui est une palette 4 d'une ancre 5 et une deuxième pièce 3 qui est une roue d'échappement 6 tel que représenté à la figure 3. Plus précisément, la palette 4 présente un plan de repos A et un plan d'impulsion B qui coopèrent avec les plans de repos C et d'impulsion D de la dent 7 de la roue d'échappement 6. Ces plans A, B, C, D sont des surfaces fonctionnelles fortement sollicitées et sujettes à des niveaux élevés de frottement et/ou contact pouvant requérir une couche tribologique selon l'invention pour réduire le frottement. Dans une autre application horlogère, la première pièce peut être un axe d'un mobile et la deuxième pièce un palier. Selon une autre application dans ce domaine, les première et deuxième pièces peuvent être des dentures de roues d'engrenage.

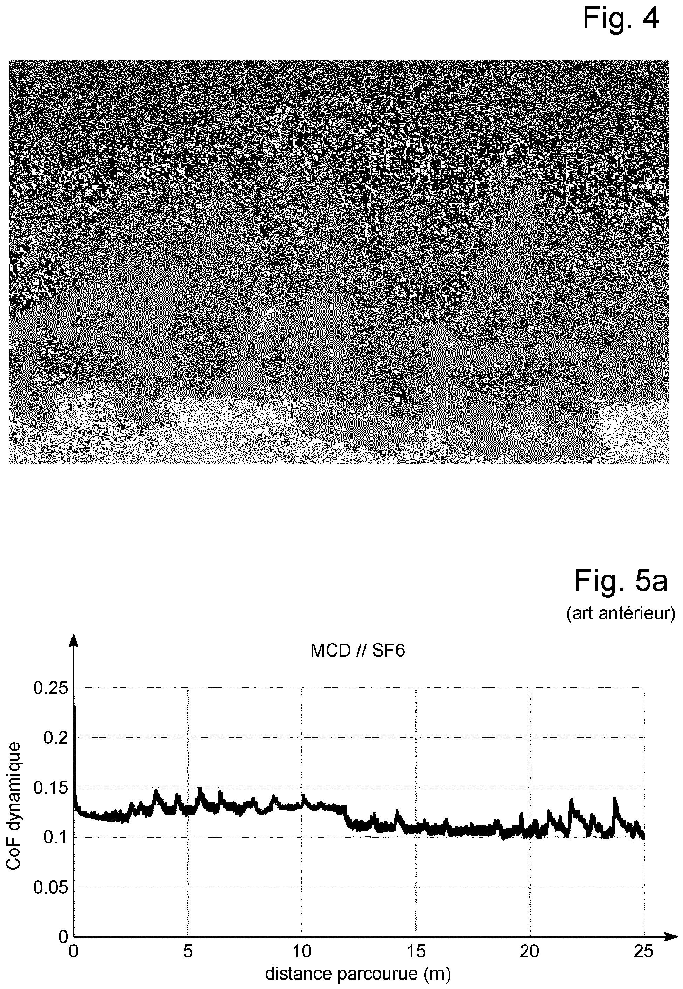

Tel que schématisé à la figure 2, l'ensemble fonctionnel 1 comporte la première pièce 2 et la deuxième pièce 3 formées d'un substrat 8 avec au moins au niveau de leur surface fonctionnelle 2a,3a la couche tribologique 9. Cette couche 9 est constituée d'une première couche de diamant 9a qui peut être du diamant ultrananocristallin (UNCD, d'après la dénomination anglaise Ultrananocrystalline Diamond), nanocristallin (NCD, d'après la dénomination anglaise Nanocrystalline Diamond) ou microcristallin (MCD, d'après la dénomination anglaise Microcrystalline Diamond). Selon l'invention, cette première couche 9a est fonctionnalisée avec un composé sulfuré, et plus spécifiquement du S et du F, qui forme une deuxième couche 9b sur la première couche 9a. Avantageusement, la première couche 9a est fonctionnalisée avec du SF6. D'autres gaz, bien que plus dangereux et d'usage plus limité, tels que le SF2 et le SF4, sont envisageables. Généralement, le S et F fonctionnalisés à la surface de la couche de diamant se présentent sous forme de bâtonnets tels que montrés à la figure 4. La deuxième couche de S et F est généralement d'épaisseur non constante et de taille nanométrique avec, selon l'invention, une épaisseur moyenne comprise entre 2 et 50 nm, de préférence entre 5 et 10 nm. Les techniques adaptées pour visualiser et analyser chimiquement la deuxième couche de S et F sont par exemple la spectrométrie photoélectronique X (en anglais, X-Ray photoelectron spectrometry : XPS) ou la spectrométrie de masse de type TOF-SIMS (en anglais, Time Of Flight Secondary Ion Mass Spectrometry). On notera que la couche étant extrême fine, il peut s'avérer difficile d'identifier précisément le composé présent. On parlera donc d'une couche comprenant du S et du F.

Selon l'invention, les surfaces destinées à être mises en contact sont chacune recouvertes de la couche de diamant fonctionnalisé au S et au F. La couche 9 incluant la première couche de diamant 9a et la deuxième couche 9b de S et de F a une épaisseur moyenne comprise entre 800 nm et 1200 nm, de préférence entre 900 et 1200 nm, et ce que ce soit du diamant MCD, NCD ou encore UNCD.

A titre d'exemple, les substrats pourront être choisis parmi l'ensemble des matériaux comprenant les céramiques, le silicium, le silicium oxydé, le silicium nitruré, le silicium carburé et les aciers. Il est également envisageable que le substrat et la couche de diamant forment un seul matériau massif. Selon un mode de réalisation préféré, le substrat est en silicium avec une couche de diamant microcristallin fonctionnalisé avec du S et du F.

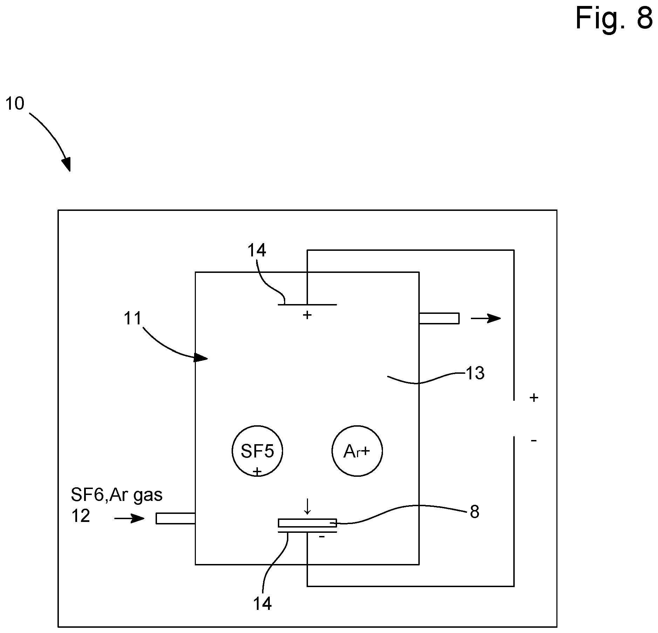

Le procédé de fonctionnalisation de la couche de diamant est le suivant. Au préalable, la couche de diamant est déposée par voie chimique en phase vapeur (CVD) ou par la technique des filaments chauds et ce si le substrat n'est pas en diamant massif. Ensuite, le soufre et le fluor sont déposés sous forme d'une deuxième couche ultra fine sur la couche de diamant par un procédé d'attaque par ions réactifs (RIE pour Reactive Ion Etching) à très faible puissance afin de réaliser un dépôt plutôt qu'un gravage. L'équipement 10 pour la fonctionnalisation du diamant avec le réacteur plasma 11 est schématisé à la figure 8. Il peut par exemple être du type « à couplage capacitif ».

Les paramètres du procédé sont les suivants :
- Gaz réactif (12) comprenant du S et du F tel que le SF6, SF4 ou SF2, avec un débit compris entre 3 et 20 sccm (pour Standard Cubic Centimeter per Minute), soit des cm³ .min⁻¹, de préférence entre 5 et 10 sccm,
- Puissance radiofréquence (RF) comprise entre 40 et 60W,
- Pression dans le réacteur comprise entre 30 et 150 µbar, de préférence entre 80 et 120 µbar,
- Temps de réaction compris entre 20 et 120 minutes, de préférence entre 30 et 70 minutes.

La deuxième couche fonctionnalisée ainsi obtenue a une épaisseur très faible, de l'ordre de quelques nanomètres, même avec un temps de réaction de l'ordre de l'heure.

Des essais ont été réalisés pour évaluer le comportement tribologique d'un ensemble fonctionnel selon l'invention.

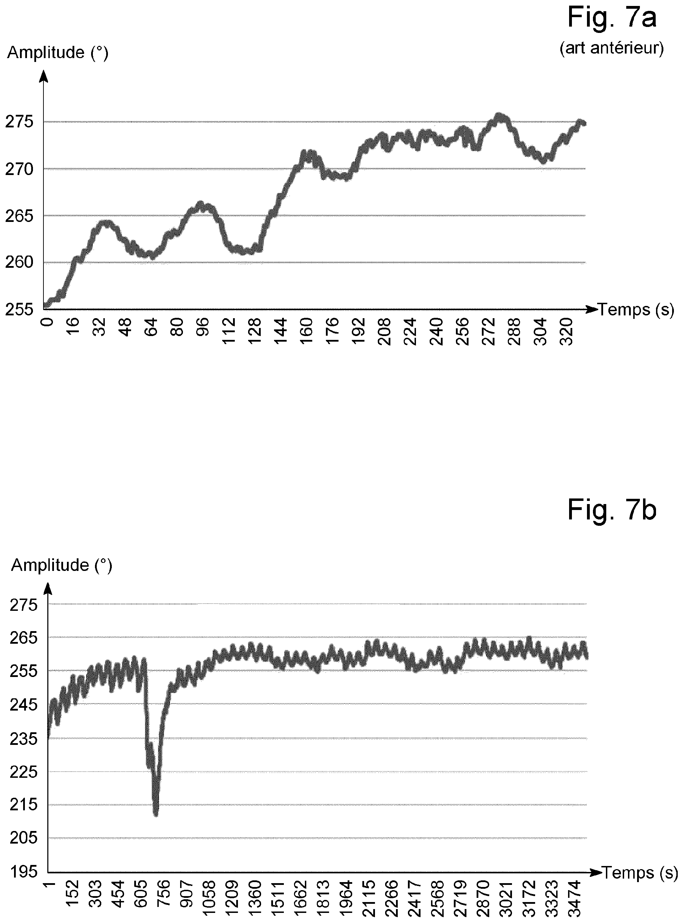

Des roues d'échappement en Si ainsi que des levées de palettes en Si ont été revêtues avec du diamant microcristallin fonctionnalisé au S et au F et plus spécifiquement au SF6. Les tests sont donc effectués avec un couple diamant fonctionnalisé sur diamant fonctionnalisé et comparé avec une ancre standard avec un contact acier lubrifié sur rubis. Des tests FEMTO-torque ont été réalisés pour mesurer le rendement d'un échappement à ancre suisse monté sur une platine de travail. Le couple appliqué était de 16 µN.m. La mesure de l'amplitude du balancier (à 3 bras) est représentée aux figures 7a et 7b respectivement pour l'ancre standard et l'ancre traitée selon l'invention. Pour l'ancre standard, l'amplitude moyenne est de 274° pour une heure de test. Pour l'ancre traitée selon l'invention, l'amplitude moyenne est de 256° pour une heure de test, soit 18° en dessous de celle de l'ancre standard. A part la défaillance temporaire à 700s, on constate que la régularité de l'amplitude est très bonne, voire meilleure que sur la version standard de référence.

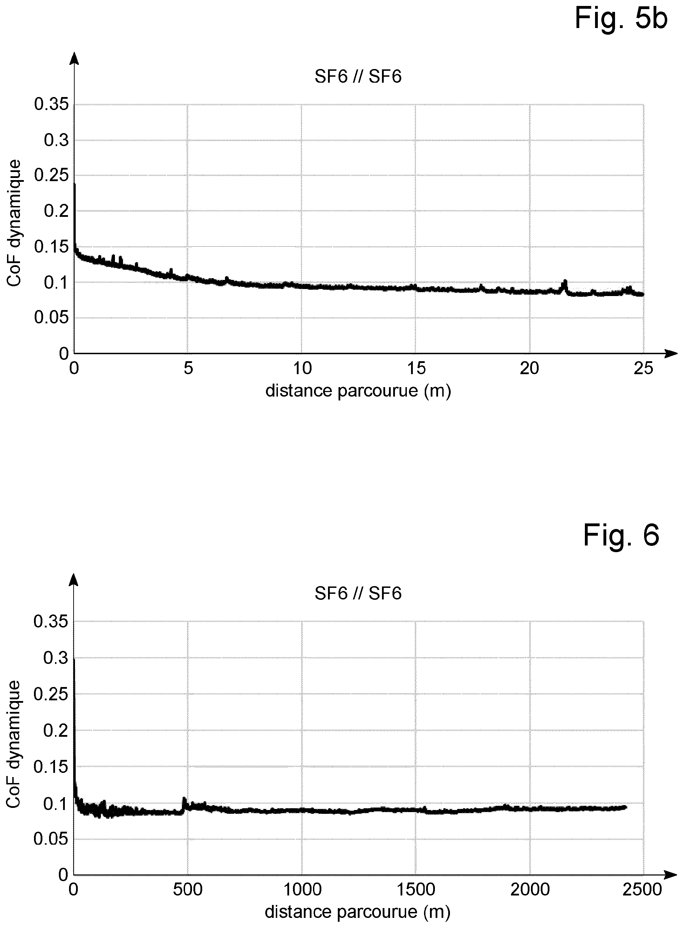

En parallèle, des tests tribologiques ont également été réalisés avec un tribomètre bille/plan avec une bille de 2 mm de diamètre pour une distance de 25 mètres et de 2500 mètres. Les essais sur 25 mètres ont été effectués avec un couple bille/plan ayant chacun un substrat en Si avec une couche de diamant fonctionnalisé au SF6 (SF6//SF6) et avec un couple comparatif bille/plan où la bille est un substrat en Si revêtu de diamant microcristallin sans fonctionnalisation et où le plan est un substrat en Si revêtu de diamant microcristallin fonctionnalisé selon l'invention (MCD//SF6). Ces essais ont pour objet de mettre en avant l'avantage de fonctionnaliser les deux surfaces en contact. Les essais ont été réalisés avec une force normale de 10 mN, une vitesse de glissement de 10 mm/s et une amplitude de 4 mm. Le coefficient de frottement dynamique en fonction de la distance est représenté aux figures 5a et 5b respectivement pour le couple comparatif et le couple selon l'invention. On constate pour le couple comparatif que le coefficient de frottement moyen est supérieur à 0.1. Il est peu stable avec de nombreux pics. Par contre, pour le couple selon l'invention, le coefficient de frottement moyen est inférieur à 0.1 et stable. Sur ce même couple selon l'invention, un test plus long sur une distance de 2500 mètres a été réalisé. Le résultat est présenté à la figure 6. Le coefficient de frottement moyen est faible et identique à celui du test court de 25 mètres. Après une petite période de rodage, le coefficient de frottement est stable sur toute la période de test.

Ainsi, les tests FEMTO-torque et les tests tribologiques confirment le très bon comportement en utilisation du couple diamant fonctionnalisé sur diamant fonctionnalisé.

### Légende

- (1): Ensemble fonctionnel
- (2): Première pièce
a) Première surface de contact, aussi dite surface fonctionnelle
- (3): Deuxième pièce
a) Deuxième surface de contact, aussi dite surface fonctionnelle
- (4): Palette
A. Plan de repos
B. Plan d'impulsion
- (5): Ancre
- (6): Roue d'échappement
- (7): Dent
C. Plan de repos
D. Plan d'impulsion
- (8): Substrat
- (9): Couche tribologique
a) Première couche comprenant du diamant
b) Deuxième couche comprenant du S et du F
- (10): Equipement pour la fonctionnalisation
- (11): Réacteur
- (12): Gaz
- (13): Plasma
- (14): Electrodes

## Revendications

1. Ensemble fonctionnel (1) de micromécanique comprenant au moins une première pièce (2) formée d'un premier substrat (8) surmonté d'une première surface fonctionnelle (2a) destinée à venir en contact de frottement avec une deuxième surface fonctionnelle (3a), ladite deuxième surface fonctionnelle appartenant, soit à ladite première pièce (2) soit à au moins une deuxième pièce (3) formée d'un deuxième substrat surmonté de ladite deuxième surface fonctionnelle (3a), la deuxième pièce (3) constituant avec ladite première pièce (2) ledit ensemble fonctionnel (1), la première surface fonctionnelle (2a) et la deuxième surface fonctionnelle (3a) étant formées d'une première couche (9a) qui est soit de matière avec le premier substrat (8) et le deuxième substrat (8) soit distincte du premier substrat (8) et du deuxième substrat (8), la première couche (9a) comprenant du diamant ultrananocristallin, nanocristallin ou microcristallin et étant surmontée d'une deuxième couche (9b) comportant des atomes de S et de, la deuxième couche (9b) ayant une épaisseur moyenne comprise entre 2 et 50 nm, de préférence entre 5 et 10 nm.

2. Ensemble fonctionnel (1) selon la revendication précédente, **caractérisé en ce que** la deuxième couche (9b) comporte du SF6.

3. Ensemble fonctionnel (1) selon l'une des revendications précédentes, **caractérisé en ce que** la deuxième couche (9b) est formée de bâtonnets.

4. Ensemble fonctionnel (1) selon l'une des revendications précédentes, **caractérisé en ce que** la première pièce (2) est une palette (4) et **en ce que** la deuxième pièce (3) est une roue d'échappement (6).

5. Ensemble fonctionnel (1) selon l'une des revendications 1 à 3, **caractérisé en ce que** la première pièce (2) est un axe d'un mobile et **en ce que** la deuxième pièce (3) est un palier.

6. Ensemble fonctionnel (1) selon l'une des revendications 1 à 3, **caractérisé en ce que** la première pièce (2) et la deuxième pièce (3) sont des dentures de roues d'engrenage.

7. Ensemble fonctionnel (1) selon l'une des revendications 1 à 3, **caractérisé en ce que** ladite deuxième surface fonctionnelle appartient à ladite première pièce (2) et **en ce que** la première pièce (2) est un ressort de barillet formé d'une lame et **en ce qu'**une face avant de ladite lame forme ladite première surface fonctionnelle et **en ce que** la face arrière de ladite lame forme ladite deuxième surface fonctionnelle.

8. Ensemble fonctionnel (1) selon l'une des revendications précédentes, **caractérisé en ce que** le premier substrat (8) et le deuxième substrat (8) sont choisis parmi les céramiques, le silicium, le silicium oxydé, le silicium nitruré, le silicium carburé et les aciers, lorsque ladite première couche (9a) est distincte du premier substrat (8) et du deuxième substrat (8).

9. Procédé de fonctionnalisation du diamant ultrananocristallin, nanocristallin ou microcristallin, comprenant les étapes suivantes :
a) Mise à disposition d'au moins un premier substrat (8) revêtu d'une première couche (9a) dudit diamant ultrananocristallin, nanocristallin ou microcristallin ou mise à disposition d'au moins un premier substrat (8) en diamant ultrananocristallin, nanocristallin ou microcristallin,
b) Fonctionnalisation dudit premier substrat (8) de l'étape a) dans un équipement (10) d'attaque par ions réactifs muni d'un réacteur (11) et d'électrodes (14), la fonctionnalisation étant opérée avec une puissance radiofréquence comprise entre 40 et 60W, avec comme gaz réactif (12) un composé comprenant du S et du F, la tension entre les électrodes (14) étant comprise entre 130 et 170V, de préférence entre 140 et 155V.

10. Procédé selon la revendication précédente, **caractérisé en ce que** le composé est du SF6.

11. Procédé selon l'une des revendications 9 ou10, **caractérisé en ce que** la pression dans le réacteur (11) est comprise entre 30 et 150 µbar, de préférence entre 80 et 120 µbar.

12. Procédé selon l'une des revendications 9 à 11, **caractérisé en ce que** le débit du gaz réactif (12) dans le réacteur (11) est compris entre 3 et 20 sccm, de préférence entre 5 et 10 sccm.

13. Procédé selon l'une des revendications 9 à 12, **caractérisé en ce que** le temps de fonctionnalisation du premier substrat (8) dans le réacteur (11) est compris entre 20 et 120 minutes, de préférence entre 30 et 70 minutes.

14. Procédé selon l'une des revendications 9 à 13, **caractérisé en ce que** l'équipement (10) est doté d'un couplage de plasma capacitif.

## Patentansprüche

1. Funktionseinheit (1) der Mikromechanik, umfassend mindestens ein erstes Bauteil (2), das aus einem ersten Substrat (8) besteht, das von einer ersten Funktionsfläche (2a) überlagert ist, die für den Gleitkontakt mit einer zweiten Funktionsfläche (3a) vorgesehen ist, wobei die zweite Funktionsfläche entweder zum ersten Bauteil (2) oder zu mindestens einem zweiten Bauteil (3) gehört, das aus einem zweiten Substrat besteht, das von der zweiten Funktionsfläche (3a) überlagert ist, wobei das zweite Bauteil (3) zusammen mit dem ersten Bauteil (2) die Funktionseinheit (1) bildet. Die erste Funktionsfläche (2a) und die zweite Funktionsfläche (3a) bestehen aus einer ersten Schicht (9a), die entweder aus demselben Material wie das erste (8) und zweite Substrat (8) besteht oder sich vom ersten (8) und zweiten (8) Substrat unterscheidet. Die erste Schicht (9a) enthält ultrananokristallinen, nanokristallinen oder mikrokristallinen Diamant und ist mit einer zweiten Schicht (9b) überlagert, die Atome von Schwefel (S) und Fluor (F) enthält, wobei die zweite Schicht (9b) eine mittlere Dicke zwischen 2 und 50 nm, vorzugsweise zwischen 5 und 10 nm, aufweist.

2. Funktionseinheit (1) nach dem vorstehenden Anspruch, **dadurch gekennzeichnet, dass** die zweite Schicht (9b) SF6 enthält.

3. Funktionseinheit (1) nach einem der vorhergehenden Ansprüche, **dadurch gekennzeichnet, dass** die zweite Schicht (9b) aus Stäbchen besteht.

4. Funktionseinheit (1) nach einem der vorhergehenden Ansprüche, **dadurch gekennzeichnet, dass** das erste Bauteil (2) eine Palette (4) und das zweite Bauteil (3) ein Ankerrad (6) ist.

5. Funktionseinheit (1) nach einem der Ansprüche 1 bis 3, **dadurch gekennzeichnet, dass** das erste Bauteil (2) eine Achse eines beweglichen Elements und das zweite Bauteil (3) ein Lager ist.

6. Funktionseinheit (1) nach einem der Ansprüche 1 bis 3, **dadurch gekennzeichnet, dass** das erste Teil (2) und das zweite Teil (3) Zahnräder sind.

7. Funktionseinheit (1) nach einem der Ansprüche 1 bis 3, **dadurch gekennzeichnet, dass** die zweite Funktionsfläche zur ersten Komponente (2) gehört und dass die erste Komponente (2) eine Feder eines Federhauses ist, die aus einem Band besteht, wobei eine Vorderseite dieses Bands die erste Funktionsfläche und die Rückseite die zweite Funktionsfläche bildet.

8. Funktionseinheit (1) nach einem der vorhergehenden Ansprüche, **dadurch gekennzeichnet, dass** das erste Substrat (8) und das zweite Substrat (8) aus Keramiken, Silizium, oxidiertem Silizium, nitridiertem Silizium, karburiertem Silizium oder Stählen gewählt sind, wenn die genannte erste Schicht (9a) vom ersten (8) und zweiten Substrat (8) verschieden ist.

9. Funktionalisierungsverfahren für ultrananokristallinen, nanokristallinen oder mikrokristallinen Diamanten, das folgende Schritte umfasst:
a) Bereitstellung mindestens eines ersten Substrats (8), das mit einer ersten Schicht (9a) des genannten ultrananokristallinen, nanokristallinen oder mikrokristallinen Diamanten beschichtet ist, oder Bereitstellung mindestens eines ersten Substrats (8) aus ultrananokristallinem, nanokristallinem oder mikrokristallinem Diamanten,
b) Funktionalisierung des in Schritt a) genannten ersten Substrats (8) in einer Anlage (10) zur reaktiven Ionenätzung, die mit einem Reaktor (11) und Elektroden (14) ausgestattet ist, wobei die Funktionalisierung mit einer Hochfrequenzleistung zwischen 40 und 60 W durchgeführt wird, unter Verwendung eines Reaktivgases (12), das eine Verbindung aus Schwefel (S) und Fluor (F) enthält, wobei die Spannung zwischen den Elektroden (14) zwischen 130 und 170 V, vorzugsweise zwischen 140 und 155 V beträgt.

10. Verfahren nach dem vorstehenden Anspruch, **dadurch gekennzeichnet, dass** die Verbindung SF6 ist.

11. Verfahren nach einem der vorstehenden Ansprüche 9 oder 10, **dadurch gekennzeichnet, dass** der Druck im Reaktor (11) zwischen 30 und 150 µbar, vorzugsweise zwischen 80 und 120 µbar liegt.

12. Verfahren nach einem der vorstehenden Ansprüche 9 bis 11, **dadurch gekennzeichnet, dass** der Durchfluss des Reaktionsgases (12) im Reaktor (11) zwischen 3 und 20 sccm, vorzugsweise zwischen 5 und 10 sccm liegt.

13. Verfahren nach einem der vorstehenden Ansprüche 9 bis 12, **dadurch gekennzeichnet, dass** die Funktionalisierungszeit des ersten Substrats (8) im Reaktor (11) zwischen 20 und 120 Minuten, vorzugsweise zwischen 30 und 70 Minuten beträgt.

14. Verfahren nach einem der vorstehenden Ansprüche 9 bis 13, **dadurch gekennzeichnet, dass** die Ausrüstung (10) mit einer kapazitiven Plasmakopplung ausgestattet ist.

## Claims

1. Micromechanical functional assembly (1) comprising at least one first part (2) formed by a first substrate (8) topped by a first functional surface (2a) intended to enter into frictional contact with a second functional surface (3a), said second functional surface belonging either to said first part (2) or to at least one second part (3) formed by a second substrate topped by said second functional surface (3a), the second part (3) constituting with said first part (2) said functional assembly (1), the first functional surface (2a) and the second functional surface (3a) being formed by a first layer (9a) which is either integral with the first substrate (8) and the second substrate (8) or distinct from the first substrate (8) and the second substrate (8), the first layer (9a) comprising ultrananocrystalline, nanocrystalline or microcrystalline diamond and being topped by a second layer (9b) including S and F atoms, the second layer (9b) having an average thickness of between 2 and 50 nm, preferably between 5 and 10 nm.

2. Functional assembly (1) according to the preceding claim, **characterised in that** the second layer (9b) includes SF6.

3. Functional assembly (1) according to any of the preceding claims, **characterised in that** the second layer (9b) is formed of rods.

4. Functional assembly (1) according to any of the preceding claims, **characterised in that** the first part (2) is a pallet (4) and **in that** the second part (3) is an escapement wheel (6).

5. Functional assembly (1) according to any of claims 1 to 3, **characterised in that** the first part (2) is a shaft of a mobile and **in that** the second part (3) is a bearing.

6. Functional assembly (1) according to any of claims 1 to 3, **characterised in that** the first part (2) and the second part (3) are gearwheel teeth.

7. Functional assembly (1) according to any of claims 1 to 3, **characterised in that** said second functional surface belongs to said first part (2) and **in that** the first part (2) is a barrel spring formed by a blade and **in that** a front face of said blade forms said first functional surface and **in that** the rear face of said blade forms said second functional surface.

8. Functional assembly (1) according to any of the preceding claims, **characterised in that** the first substrate (8) and the second substrate (8) are selected from ceramics, silicon, oxidised silicon, nitrided silicon, carburised silicon and steels, when said first layer (9a) is distinct from the first substrate (8) and the second substrate (8).

9. Method for functionalising ultrananocrystalline, nanocrystalline or microcrystalline diamond, comprising the following steps:
a) providing at least one first substrate (8) coated with a first layer (9a) of said ultrananocrystalline, nanocrystalline or microcrystalline diamond or providing at least one first substrate (8) made of ultrananocrystalline, nanocrystalline or microcrystalline diamond,
b) functionalising said first substrate (8) of step a) in reactive ion etching equipment (10) provided with a reactor (11) and electrodes (14), the functionalisation being performed at a radiofrequency power of between 40 and 60W, with as reactive gas (12) a compound comprising S and F, the voltage between the electrodes (14) being between 130 and 170V, preferably between 140 and 155V.

10. Method according to the preceding claim, **characterised in that** the compound is SF6.

11. Method according to any of claims 9 or 10, **characterised in that** the pressure in the reactor (11) is between 30 and 150 µbar, preferably between 80 and 120 µbar.

12. Method according to any of claims 9 to 11, **characterised in that** the flow rate of the reactant gas (12) in the reactor (11) is between 3 and 20 sccm, preferably between 5 and 10 sccm.

13. Method according to any of claims 9 to 12, **characterised in that** the functionalising time of the first substrate (8) in the reactor (11) is between 20 and 120 minutes, preferably between 30 and 70 minutes.

14. Method according to any of claims 9 to 13, **characterised in that** the equipment (10) is provided with a capacitive plasma coupling.
